# EUROPÄISCHE PATENTANMELDUNG

(11) **EP 1 933 447 A2**
(43) Veröffentlichungstag der Anmeldung: **18.06.2008**
(21) Anmeldenummer: 07116887.6
(22) Anmeldetag: 21.09.2007
(51) Int. Cl.: H02M 1/08

(54) **Schaltungsanordnung zur Ansteuerung von Schalttransistoren**

(30) Priorität: 13.12.2006 AT 20512006
(71) Anmelder: SIEMENS AKTIENGESELLSCHAFT ÖSTERREICH, 1210 Wien (AT)
(72) Erfinder: Appel, Wilhelm, 2136 Laa a. d. Thaya (AT); Eihhorner, Bernhard, 1210 Wien (AT); Peprny, Wolfgang, 1210 Wien (AT); Schönleitner, Arnold, 1130 Wien (AT)

(57) **Zusammenfassung**

Schaltungsanordnung zum wechselnden Verbinden einer Last (L1) mit unterschiedlichen Versorgungspotentialen, die zwei seriell geschaltene Halbleiterschalter (V1, V2) mit jeweiligen Ansteuertreibern (A1, A2) aufweist, wobei die beiden Halbleiterschalter (V1, V2) mit einer Versorgungsspannung (Vᵢₙ) verbunden sind, und zwischen den beiden Halbleiterschaltern (V1, V2) die Primärwicklung eines Transformators (T1) geschalten ist, dessen Sekundärwicklung mit der Last (L1) verbunden ist. Erfindungsgemäß ist vorgesehen, dass der erste Ansteuertreiber (A1) mit der Versorgungsspannung (Vᵢₙ) verbunden ist, und der zweite Ansteuertreiber (A2) mit einer Hilfswicklung (W1) des Transformators (T1). Des Weiteren ist eine Diode (D2) vorgesehen, die eingangsseitig mit der Versorgungsschaltung des ersten Ansteuertreibers (A1) verbunden ist, und ausgangsseitig mit der Versorgungsschaltung für den zweiten Ansteuertreiber (A2). Alternativ kann auch eine Diode (D4) vorgesehen sein, die eingangsseitig über einen seriell geschalteten Kondensator (C4) mit dem zweiten Anschluss der Versorgungsspannung (Vᵢₙ) verbunden ist, und ausgangsseitig mit der Versorgungsschaltung für den zweiten Ansteuertreiber (A2).

## Beschreibung

Die Erfindung bezieht sich auf eine Schaltungsanordnung zum wechselnden Verbinden einer Last mit unterschiedlichen Versorgungspotentialen, die einen ersten Halbleiterschalter, dessen Gate mit einem ersten Ansteuertreiber verbunden ist, und einen seriell geschalteten zweiten Halbleiterschalter, dessen Gate mit einem zweiten Ansteuertreiber verbunden ist, aufweist, wobei der Source-Anschluss des ersten Halbleiterschalters mit einem ersten Anschluss einer Versorgungsspannung verbunden ist, und der Drain-Anschluss des zweiten Halbleiterschalters mit dem zweiten Anschluss der Versorgungsspannung, und zwischen dem Drain-Anschluss des ersten Halbleiterschalters und dem Source-Anschluss des zweiten Halbleiterschalters die Primärwicklung eines Transformators geschalten ist, dessen Sekundärwicklung mit der Last verbunden ist, gemäß dem Oberbegriff von Anspruch 1.

Schaltungsanordnungen dieser Art sind in der Leistungselektronik weit verbreitet, und finden sich etwa in Schaltnetzteilen, wobei es sich bei den Halbleiterschaltern zumeist um Leistungsschalter handelt. Bei komplexen Schaltungen in der Leistungselektronik sind vielfach mehrere Leistungsschalter vorhanden, die sich auf verschiedenen Spannungspotentialen befinden. Jedem dieser Schalter ist neben dem Schaltbefehl auch die Energieversorgung für die Ansteuertreiber zur Verfügung zu stellen. Bei Schaltnetzteilen etwa kann diese Energie mithilfe einer Hilfswicklung am Transformator, der im Folgenden auch als "Hauptübertrager" bezeichnet wird, bezogen werden. Der Einsatz von Hilfswicklungen für die Versorgung der unterschiedlichen Ansteuertreiber ist aber bislang an geeigneten "Start-up"-Schaltungen gescheitert, also Versorgungsschaltungen, die die Energie für den ersten Schaltimpuls liefern, da die Hilfswicklungen erst mit diesem ersten Taktimpuls die Versorgung übernehmen können.

Im Stand der Technik wird dieses Problem etwa mithilfe eigener "Impulsübertrager" gelöst, bei denen neben dem ersten Schaltimpuls auch die Ansteuerenergie über einen separaten Übertrager geliefert wird. Impulsübertrager weisen aber einen vergleichsweise aufwändigen Aufbau auf und bedeuten daher einen Kosten- und Volumennachteil. Darüber weisen Impulsübertrager aber auch andere Nachteile auf, wie etwa Probleme bei der Übertragung von sehr großen oder kleinen Tastverhältnissen, da keine Gleichspannungsanteile übertragen werden können.

Alternativ kann die Ansteuerenergie auch durch ein eigenes Netzgerät bereitgestellt werden, was aber wiederum erhebliche Kosten- und Volumennachteile nach sich zieht.

Es ist daher die Aufgabe der Erfindung, diese Nachteile zu vermeiden und eine Schaltanordnung zu verwirklichen, die auf einfache und somit kostengünstige Art und Weise sowohl die Energieversorgung für die Ansteuertreiber, als auch für den ersten Schaltimpuls liefert. Insbesondere bei elektronischer Massenware, wie etwa Schaltnetzteilen, kann jede Vereinfachung des technischen Aufbaus einen großen Kostenvorteil darstellen.

Dieses Ziel wird mit den Merkmalen von Anspruch 1 erreicht. Anspruch 1 bezieht sich auf eine Schaltungsanordnung zum wechselnden Verbinden einer Last mit unterschiedlichen Versorgungspotentialen, die einen ersten Halbleiterschalter, dessen Gate mit einem ersten Ansteuertreiber verbunden ist, und einen seriell geschalteten zweiten Halbleiterschalter, dessen Gate mit einem zweiten Ansteuertreiber verbunden ist, aufweist, wobei der Source-Anschluss des ersten Halbleiterschalters mit einem ersten Anschluss einer Versorgungsspannung verbunden ist, und der Drain-Anschluss des zweiten Halbleiterschalters mit dem zweiten Anschluss der Versorgungsspannung, und zwischen dem Drain-Anschluss des ersten Halbleiterschalters und dem Source-Anschluss des zweiten Halbleiterschalters die Primärwicklung eines Transformators geschalten ist, dessen Sekundärwicklung mit der Last verbunden ist. Erfindungsgemäß ist hierbei nun vorgesehen, dass eine Versorgungsschaltung für den ersten Ansteuertreiber gebildet wird, indem die Anschlussklemmen des ersten Ansteuertreibers mittelbar oder unmittelbar mit dem ersten und zweiten Anschluss der Versorgungsspannung verbunden sind, und eine Versorgungsschaltung für den zweiten Ansteuertreiber gebildet wird, indem die Anschlussklemmen des zweiten Ansteuertreibers mittelbar oder unmittelbar mit einer Hilfswicklung des Transformators verbunden sind, wobei eine Diode vorgesehen ist, die eingangsseitig mit der Versorgungsschaltung des ersten Ansteuertreibers verbunden ist, und ausgangsseitig mit der Versorgungsschaltung für den zweiten Ansteuertreiber. Wie im Folgenden noch näher ausgeführt wird, kann mithilfe dieser Maßnahmen erreicht werden, dass nach dem Einschalten der Versorgungsspannung über die Diode Ansteuerenergie für den zweiten Ansteuertreiber bereitgestellt wird, die den ersten Schaltimpuls auslöst.

Gemäß einer zweiten und alternativen Möglichkeit ist vorgesehen, dass zunächst wie vorangehend beschrieben eine Versorgungsschaltung für den ersten Ansteuertreiber gebildet wird, indem die Anschlussklemmen des ersten Ansteuertreibers mittelbar oder unmittelbar mit dem ersten und zweiten Anschluss der Versorgungsspannung verbunden sind, und eine Versorgungsschaltung für den zweiten Ansteuertreiber gebildet wird, indem die Anschlussklemmen des zweiten Ansteuertreibers mittelbar oder unmittelbar mit einer Hilfswicklung des Transformators verbunden sind, wobei aber nun im Unterschied zur vorangehend beschrieben Ausführungsweise eine Diode vorgesehen ist, die eingangsseitig über einen seriell geschalteten Kondensator mit dem zweiten Anschluss der Versorgungsspannung verbunden ist, und ausgangsseitig mit der Versorgungsschaltung für den zweiten Ansteuertreiber. Auch mit einer solchen Ausführung wird erreicht, dass nach dem Einschalten der Versorgungsspannung über die Diode Ansteuerenergie für den zweiten Ansteuertreiber bereitgestellt wird, die den ersten Schaltimpuls auslöst. In einer besonderen Ausführungsweise der erfindungsgemäßen Schaltungsanordnung ist für den Kondensator ein Entladewiderstand vorgesehen, um rasch einen weiteren Einschaltvorgang zu ermöglichen.

Gemäß einer bevorzugten Ausführungsvariante der Erfindung wird der erste Halbleiterschalter als low-side-Schalter betrieben, und der zweite Halbleiterschalter als high-side-Schalter.

Die erfindungsgemäße Schaltungsanordnung bietet insbesondere den Vorteil, dass auf aufwändige Versorgungsschaltungen für den Ansteuertreiber, wie etwa Impulsübertrager, verzichtet werden kann. Dadurch ist es bevorzugten Ausführungsvariante der Erfindung etwa möglich, dass die Ansteuerinformation für die Ansteuertreiber mithilfe optischer Systeme erfolgt, etwa mithilfe eines Optokopplers.

Alternativ dazu kann die Ansteuerinformation für zumindest einen Ansteuertreiber jedoch auch mithilfe eines induktiv oder kapazitiv wirkenden Übertragers erfolgen.

Erfindungsgemäß ist schließlich ein Schaltnetzteil vorgesehen, welches eine Schaltungsanordnung nach einem der vorangehenden Ansprüche aufweist.

Die Erfindung wird im Folgenden anhand zweier Ausführungsformen mithilfe der beiliegenden Figuren näher erläutert. Es zeigen hierbei die
Fig. 1 eine Darstellung einer erfindungsgemäßen Schaltungsanordnung für ein Schaltnetzteil gemäß einer ersten Ausführungsform, und
Fig. 2 eine Darstellung einer erfindungsgemäßen Schaltungsanordnung für ein Schaltnetzteil gemäß einer zweiten Ausführungsform.

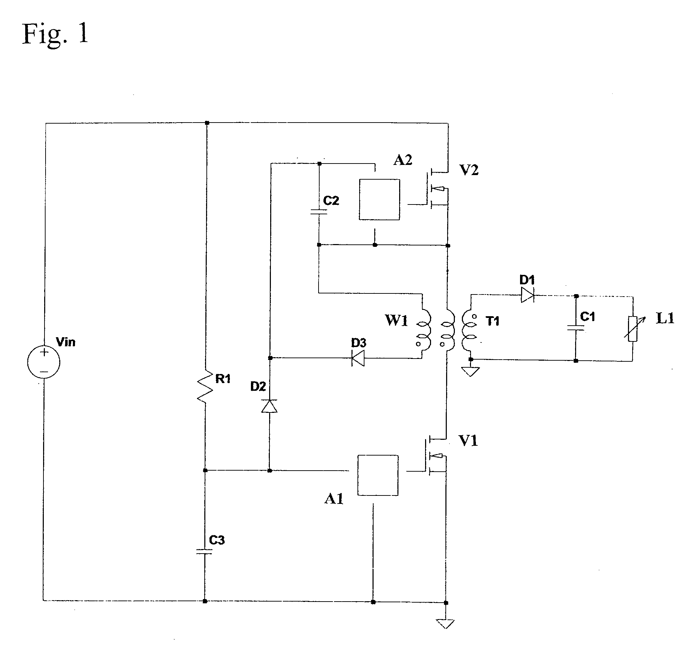

In der Fig. 1 ist ein primärgetaktetes Schaltnetzteil mit zwei seriell geschaltenen Halbleiterschaltern V1, V2 dargestellt, die sich auf zwei verschiedene Potentiale beziehen. Bei den Halbleiterschaltern V1, V2 handelt es sich vorzugsweise um unipolare Transistoren, etwa um Leistungs-MOSFET, wobei in der Ausführungsform gemäß der Fig. 1 der erste Halbleiterschalter V1 als low side Transistor betrieben wird, und der zweite Halbleiterschalter V2 als high side Transistor. Zwischen den beiden Halbleiterschaltern V1, V2 ist die Primärwicklung eines Transformators T1 seriell geschalten, dessen Sekundärwicklung mit einer Last L1 verbunden ist. Auf der Sekundärseite kann auch eine Gleichrichter- und Glättungsstufe vorgesehen sein, etwa mithilfe einer Diode D1 und einem Kondensator C1. Auf der Primärseite wird an die beiden Halbleiterschalter V1, V2, wie in der Fig. 1 dargestellt wird, die Versorungsspannung Vᵢₙ gelegt.

Der erste Halbleiterschalter V1 wird von einem ersten Ansteuertreiber A1 angesteuert, und der zweite Halbleiterschalter von einem zweiten Ansteuertreiber A2. Es handelt sich dabei um herkömmliche Ansteuertreiber A1, A2 für Halbleiterschalter V1, V2, die dem Fachmann wohlbekannt sind. Für den ersten Ansteuertreiber A1 ist eine Versorgungsschaltung vorgesehen, bei der Anschlussklemmen des ersten Ansteuertreibers A1 mittelbar oder unmittelbar mit dem ersten und zweiten Anschluss der Versorgungsspannung Vᵢₙ verbunden sind. In der Ausführungsform von Fig. 1 ist dabei etwa der erste Ansteuertreiber A1 seriell mit einem Widerstand R1, und parallel mit einem Kondensator C3 geschalten. Für die Versorgungsschaltung für den zweiten Ansteuertreiber A2 ist vorgesehen, dass die Anschlussklemmen des zweiten Ansteuertreibers A2 mittelbar oder unmittelbar mit einer Hilfswicklung W1 des Transformators T1 verbunden sind. In der Ausführungsform von Fig. 1 ist dabei etwa der zweite Ansteuertreiber A2 seriell mit einer Diode D3, und parallel mit einem Kondensator C2 geschalten.

Nach dem Zuschalten der Versorgungsspannung Vᵢₙ wird am ersten Ansteuertreiber A1 für den ersten Halbleiterschalter V1, also am low side Transistor, über die durch die Versorungsspannung Vᵢₙ, den Widerstand R1 und den Kondensator C3 gebildete Versorgungsschaltung eine Spannung bereitgestellt. Daraufhin schaltet der Ansteuertreiber A1 für den ersten Halbleiterschalter V1 den ersten Halbleiterschalter V1 ein. Zu diesem Zeitpunkt ist aber die Ansteuerleistung für den zweiten Halbleiterschalter V2, also den high side Transistor, noch nicht vorhanden. Nach dem Einschalten des ersten Halbleiterschalters V1 ist das Potential an dessen Drainanschluss nahezu null bezogen auf Masse. Da der Transformator T1 noch nicht stromdurchflossen ist, ist damit die Spannung am Sourceanschluss des zweiten Halbleiterschalters V2 ebenfalls nahezu null.

Erfindungsgemäß ist daher des Weiteren eine Diode D2 vorgesehen, die eingangsseitig mit der Versorgungsschaltung des ersten Ansteuertreibers A1 verbunden ist, und ausgangsseitig mit der Versorgungsschaltung für den zweiten Ansteuertreiber A2. Wenn die Spannung am Source des zweiten Halbleiterschalters V2, also am high side Transistor, nahezu null ist, und die Spannung am zweiten Ansteuertreiber A2 für den zweiten Halbleiterschalter V2 noch null ist, wird die Diode D2 leitend und versorgt den zweiten Ansteuertreiber A2 für den zweiten Halbleiterschalter V2. Nachdem der zweite Halbleiterschalter V2 nun einschaltet, kann die Versorgung des zweiten Ansteuertreibers A2 für den zweiten Halbleiterschalter V2 über die Hilfswicklung W1 des Transformators T1 übernommen werden.

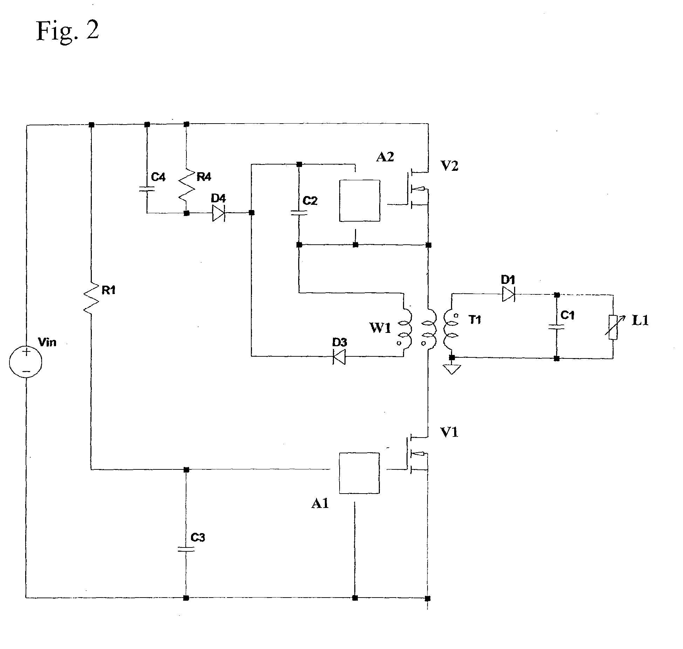

In der Fig. 2 ist eine alternative Ausführungsform für die erfindungsgemäße Schaltungsanordnung gezeigt. Hierbei wird die Versorgungsschaltung für den ersten Ansteuertreiber A1 wie im Ausführungsbeispiel gemäß der Fig. 1 gebildet, und auch die Versorgungsschaltung für den zweiten Ansteuertreiber A2 wird wiederum mithilfe einer Hilfswicklung W1 des Transformators T1 gebildet. Allerdings ist nun eine Diode D4 vorgesehen, die eingangsseitig über einen seriell geschalteten Kondensator C4 mit dem zweiten Anschluss der Versorgungsspannung Vᵢₙ verbunden ist, und ausgangsseitig mit der Versorgungsschaltung für den zweiten Ansteuertreiber A2. Der Strom zum Laden von C4 ermöglicht dabei die Versorgung des zweiten Ansteuertreibers A2 für den zweiten Halbleiterschalter V2, also den high side Transistor. Wenn der zweite Halbleiterschalter V2 nun einschaltet, kann die Versorgung des zweiten Ansteuertreibers A2 für den zweiten Halbleiterschalter V2 wiederum über die Hilfswicklung W1 am Transformator T1 übernommen werden. Nach Abschalten des Schaltnetzteiles durch Abschalten der Versorgungsspannung Vᵢₙ wird der Kondensator C4 über einen Entladewiderstand R4 entladen, um einen weiteren Einschaltvorgang zu ermöglichen.

Durch die erfindungsgemäße Schaltungsanordnung zur Versorgung des Ansteuertreibers A2 für den zweiten Halbleiterschalter V2, also den high side Transistor, wird somit Energie zur Verfügung gestellt, welche zumindest das erste Einschalten des zugehörigen Halbleiterschalters V2 ermöglicht. Gegenüber dem Stand der Technik hat dies somit insbesondere den Vorteil, dass die Verwendung eines Impulsübertragers entfallen kann, weil die Versorgung auf andere Weise erfindungsgemäß gelöst ist. Die Ansteuerinformation kann daher in vorteilhafter Weise auch mittels optischer Systeme, z.B. mithilfe von Optokopplern, vorgenommen werden. Darüberhinaus entfallen die geläufigen Nachteile der Impulsübertrager wie z.B. die Probleme bei Übertragung von sehr großen oder kleinen Tastverhältnissen. Auch auf ein separates Netzgerät für die Ansteuertreiber A1, A2 kann mithilfe der erfindungsgemäßen Schaltungsanordnung verzichtet werden, woraus sich insgesamt ein erheblicher Kosten- und Volumenvorteil ergibt.

Es ist ebenfalls möglich, die Ansteuerinformation mithilfe induktiv oder kapazitiv wirkender Übertrager zu übermitteln, deren Bauteilgröße in etwa jener der Optokoppler entspricht.

## Patentansprüche

1. Schaltungsanordnung zum wechselnden Verbinden einer Last (L1) mit unterschiedlichen Versorgungspotentialen, die einen ersten Halbleiterschalter (V1), dessen Gate mit einem ersten Ansteuertreiber (A1) verbunden ist, und einen seriell geschalteten zweiten Halbleiterschalter (V2), dessen Gate mit einem zweiten Ansteuertreiber (A2) verbunden ist, aufweist, wobei der Source-Anschluss des ersten Halbleiterschalters (V1) mit einem ersten Anschluss einer Versorgungsspannung (Vᵢₙ) verbunden ist, und der Drain-Anschluss des zweiten Halbleiterschalters (V2) mit dem zweiten Anschluss der Versorgungsspannung (Vᵢₙ), und zwischen dem Drain-Anschluss des ersten Halbleiterschalters (V1) und dem Source-Anschluss des zweiten Halbleiterschalters (V2) die Primärwicklung eines Transformators (T1) geschalten ist, dessen Sekundärwicklung mit der Last (L1) verbunden ist, **dadurch gekennzeichnet, dass** eine Versorgungsschaltung für den ersten Ansteuertreiber (A1) gebildet wird, indem die Anschlussklemmen des ersten Ansteuertreibers (A1) mittelbar oder unmittelbar mit dem ersten und zweiten Anschluss der Versorgungsspannung (Vᵢₙ) verbunden sind, und eine Versorgungsschaltung für den zweiten Ansteuertreiber (A2) gebildet wird, indem die Anschlussklemmen des zweiten Ansteuertreibers (A2) mittelbar oder unmittelbar mit einer Hilfswicklung (W1) des Transformators (T1) verbunden sind, wobei eine Diode (D2) vorgesehen ist, die eingangsseitig mit der Versorgungsschaltung des ersten Ansteuertreibers (A1) verbunden ist, und ausgangsseitig mit der Versorgungsschaltung für den zweiten Ansteuertreiber (A2).

2. Schaltungsanordnung nach Anspruch 1, **dadurch gekennzeichnet, dass** eine Versorgungsschaltung für den ersten Ansteuertreiber (A1) gebildet wird, indem die Anschlussklemmen des ersten Ansteuertreibers (A1) mittelbar oder unmittelbar mit dem ersten und zweiten Anschluss der Versorgungsspannung (Vᵢₙ) verbunden sind, und eine Versorgungsschaltung für den zweiten Ansteuertreiber (A2) gebildet wird, indem die Anschlussklemmen des zweiten Ansteuertreibers (A2) mittelbar oder unmittelbar mit einer Hilfswicklung (W1) des Transformators (T1) verbunden sind, wobei eine Diode (D4) vorgesehen ist, die eingangsseitig über einen seriell geschalteten Kondensator (C4) mit dem zweiten Anschluss der Versorgungsspannung (Vᵢₙ) verbunden ist, und ausgangsseitig mit der Versorgungsschaltung für den zweiten Ansteuertreiber (A2).

3. Schaltungsanordnung nach Anspruch 2, **dadurch gekennzeichnet, dass** für den Kondensator (C4) ein Entladewiderstand (R4) vorgesehen ist.

4. Schaltungsanordnung nach einem der Ansprüche 1 bis 3, **dadurch gekennzeichnet, dass** der erste Halbleiterschalter (V1) ein low-side-Schalter ist, und der zweite Halbleiterschalter (V2) ein high-side-Schalter.

5. Schaltungsanordnung nach einem der Ansprüche 1 bis 4, **dadurch gekennzeichnet, dass** die Ansteuerinformation für zumindest einen Ansteuertreiber (A1, A2) mithilfe eines optischen Systems erfolgt.

6. Schaltungsanordnung nach Anspruch 5, **dadurch gekennzeichnet, dass** es sich bei dem optischen System um einen Optokoppler handelt.

7. Schaltungsanordnung nach einem der Ansprüche 1 bis 4, **dadurch gekennzeichnet, dass** die Ansteuerinformation für zumindest einen Ansteuertreiber (A1, A2) mithilfe eines induktiv oder kapazitiv wirkenden Übertragers erfolgt.

8. Schaltnetzteil mit einer Schaltungsanordnung nach einem der Ansprüche 1 bis 7.
